Europäisches Patentamt

European Patent Office

Office européen des brevets

(11) Veröffentlichungsnummer: **0 313 964 B1**

# EUROPÄISCHE PATENTSCHRIFT

(45) Veröffentlichungstag der Patentschrift: **12.01.94**

(51) Int. Cl.5: **H01L 39/24**

(21) Anmeldenummer: **88117316.5**

(22) Anmeldetag: **18.10.88**

(54) **Verfahren zum Einstellen der Sprungtemperatur, der Sättigungsstromdichte mit und ohne Magnetfeld und der Anteile normalleitender Phasen von keramischen Supraleitern.**

(30) Priorität: **27.10.87 DE 3736301**

(43) Veröffentlichungstag der Anmeldung:
**03.05.89 Patentblatt 89/18**

(45) Bekanntmachung des Hinweises auf die
Patenterteilung:
**12.01.94 Patentblatt 94/02**

(84) Benannte Vertragsstaaten:
**AT CH DE ES FR GB IT LI NL SE**

(56) Entgegenhaltungen:
**WO-A-88/09061**
**WO-A-89/00343**
**US-A- 4 456 506**

**JOURNAL OF APPLIED PHYSICS, Band 58,
Nr. 1, 1. Juli 1985, Seiten 313-320; D. PRIBAT
et al.: "Interface oxidation of epitaxial silicon
deposits on (100) yttria stabilized cubic zirconia"**

**PATENT ABSTRACTS OF JAPAN, Band 13,
Nr. 273 (C-609)(3621), 22. Juni 1989; & JP-
A-16 9580**

(73) Patentinhaber: **BASF Aktiengesellschaft
Carl-Bosch-Strasse 38
D-67063 Ludwigshafen(DE)**

(72) Erfinder: **Goepel, Wolfgang, Prof. Dr.
Hainbuchenweg 29
D-7400 Tuebingen(DE)**
Erfinder: **Wiemhoefer, Hans-Dieter, Dr.
Jahnstrasse 28
D-7412 Eningen(DE)**

**Beschreibung**

Die Erfindung betrifft ein Verfahren zum Einstellen der Sprungtemperatur, der Sättigungsstromdichte mit und ohne Magnetfeld und der Anteile normalleitender Phasen von keramischen Supraleitern mit vom Perowskit abgeleiteter Struktur durch Veränderung des Gehalts der elektronegativen Komponente bzw. - bei Vorhandensein mehrerer - einer der elektronegativen Komponenten im Ionengitter des Supraleiters.

Die in der Zeitschrift für Physik, B 64, 189 (1986) erschienene Arbeit von J. G. Bednorz und K. A. Müller hat den Untersuchungen auf dem Gebiet der Supraleitung eine neue Richtung gegeben, indem sie auf die Möglichkeit einer Supraleitung mit vergleichsweise hohen Sprungtemperaturen bei keramischen Materialien im La-Ba-Cu-O-System hinwiesen. Im Rahmen der dadurch ausgelösten Aktivitäten haben sich insbesondere Materialien auf der Grundlage einer vom Perowskit abgeleiteten Struktur als aussichtsreich herausgestellt. So beschreiben P. K. Gallagher et al in der Mat. Res. Bull., Vol. 22, Seiten 995ff (1987) bei der Verbindung $Ba_2YCu_3O_{7-\delta}$ den Einfluß der Sauerstoffstöchiometrie bzw. eigentlich den der Nichtstöchiometrie auf die Sprungtemperatur ($T_c$). Die Einstellung des Sauerstoffgehalts in diesen Stoffen erfolgt dabei durch die Vorgabe eines bestimmten Sauerstoffpartialdrucks und gleichzeitiges Erhitzen des perowskitischen Materials auf Temperaturen bis zu 900°C. Aus Gründen der Reaktionskinetik sind bei der beschriebenen Verfahrensweise Temperaturen unter 400°C nicht geeignet.

Über einen teilweisen Ersatz des Sauerstoffs in den Supraleitern mit vom Perowskit abgeleiteter Struktur durch Fluor und über die sich daraus ergebende Veränderung der Sprungtemperatur berichten S. R. Ovshinsky et al in Phy. Rev. Letters, Vol. 58, Nr. 24, Seiten 2579-2581 (1987). Auch hier bedarf es zur Herstellung dieser Materialien eines hohen Sauerstoffpartialdrucks und hoher Temperaturen.

Nachteilig an den beschriebenen Vorgehensweisen ist vor allem die hohe Präparationstemperatur von bis zu 900°C und die bei der Abkühlphase nach dieser Behandlung unkontrolliert ablaufenden Änderungen von Kristallstruktur und chemischer Zusammensetzung. In der sich daran anschließenden Abkühlungsphase bedarf es besonderer Maßnahmen, kristallinen Aufbau und chemische Zusammensetzung dieser Stoffe beizubehalten und für die vorgesehene Arbeitstemperatur der Supraleitern festzulegen. Darüber hinaus können bei dieser Präparationsmethode bei der späteren Verwendung der so erhaltenen Supraleiter Alterungserscheinungen auftreten. Damit sind aber sowohl bezüglich der Sprungtemperatur, der Sättigungsstromdichte mit und ohne Magnetfeld und der Anteile normalleitender Phasen als auch der allgemeinen Verwendungsmöglichkeiten in der elektronischen Anwendung, z.B. bei Magnetfeldsensoren, Grenzen gesetzt.

Es bestand daher die Aufgabe, ein Verfahren zur Einstellung der Sprungtemperatur, der Sättigungsstromdichte mit und ohne Magnetfeld und der Anteile normalleitender Phasen von keramischen Supraleitern mit Perowskit abgeleiteter Struktur bereitzustellen, das die vorgenannten Nachteile weitgehend ausschließt und insbesondere war es Aufgabe der Erfindung ein Verfahren zur Einstellung der Sprungtemperatur, der Sättigungsstromdichte mit und ohne Magnetfeld und der Anteile normalleitender Phasen im Rahmen einer Tieftemperaturpräparation zu ermöglichen.

Es wurde nun gefunden, daß sich mit einem Verfahren zur Einstellung der Sprungtemperatur, der Sättigungsstromdichte mit und ohne Magnetfeld und der Anteile normalleitender Phasen bei keramischen Supraleitern mit Perowskit abgeleiteter Struktur durch Veränderung des Gehalts mindestens einer der elektronegativen Komponenten im Ionengitter des Supraleiters die Aufgabe lösen läßt, wenn

(1) auf einer Seite eines ionenleitenden Substrats, dessen bewegliche Ionensorte $X^{n-}$ einer elektronegativen Komponente X des Supraleiters entspricht, ein Supraleiter mit vom Perowskit abgeleiteter Struktur aufgebracht und

(2) auf der freien Seite des Supraleiters ein elektronenleitender Kontakt und ein zweiter elektronenleitender Kontakt an einer freien Seite des Ionenleiters angebracht wird, sowie

(3) dann am elektronenleitenden Kontakt auf der Seite des Ionenleiters das chemische Potential der elektronegativen Komponente X vorgegeben wird und

(4) schließlich durch ein bis zum Stromfluß Null dauerndes Anlegen einer konstanten Spannung der Gehalt der elektronegativen Komponente X im Ionengitter des Supraleiters eingestellt wird.

In einer weiteren vorteilhaften Ausgestaltung wird beim erfindungsgemäßen Verfahren die Einstellung des Gehalts der elektronegativen Komponente X im Ionengitter des Supraleiters auch durch einen konstanten Stromfluß über die beiden elektronenleitenden Kontakte eingestellt. Dieser Stromfluß wird dabei im allgemeinen solange aufrechterhalten, bis die stromlos meßbare Spannung zwischen den elektronenleitenden Kontakten einen Wert annimmt, der dem gewünschten Gehalt der elektronegativen Komponente X gemäß der für die maximale Sprungtemperatur des Supraleiters vorgegebenen Zusammensetzung entspricht. Dies wird über die stromlose Messung der Spannung bei kurzer Unterbrechung des Stroms kontrolliert.

Gemäß dem erfindungsgemäßen Verfahren bedeutet die Veränderung des Gehalts mindestens einer der elektronegativen Komponenten im Ionengitter des Supraleiters, daß beim Vorhandensein nur einer Komponente deren Gehalt verändert wird und beim Vorhandensein mehrerer unterschiedlicher Komponenten mindestens der Gehalt einer dieser Komponenten verändert wird.

Supraleiter der angegebenen Struktur sind insbesondere solche der Formel

$$A_x B_y Cu_z X_{t-\delta}.$$

Hierbei bedeuten A mindestens ein Element der Seltenen Erden, B mindestens eines der Erdalkalimetalle und X Sauerstoff oder Sauerstoff zusammen mit Fluor. Beispiele sind $La_{1,85}Sr_{0,15}CuO_{4-\delta}$ und $YBa_2 Cu_3 O_{7-\delta}$. Diese Strukturen sind von der idealen Perowskit-Struktur abgeleitet, die zwei Metallatome auf je drei Sauerstoffatome enthält. Die oxidischen Supraleiter haben gegenüber dem idealen Perowskit einen deutlich geringeren Sauerstoffgehalt, so daß

$$3/2 \ (x + y + z) > t\text{-}\delta.$$

Dabei ist $\delta$ eine Zahl kleiner als eins oder um eins und beschreibt vom Sauerstoffpartialdruck abhängige Änderungen im Sauerstoffgehalt der Supraleiter. Das erfindungsgemäße Verfahren hängt nicht von der Art der Metallatome A und B sowie von den speziellen Werten für x,y,z,t ab, da es sich nur auf den Gehalt der elektronegativen Komponente bei konstanten Koeffizienten x,y,z bezieht.

Die Herstellung dieser Materialien ist bekannt und erfolgt im allgemeinen durch Vermischen von Carbonaten, Nitraten oder binären Oxiden der enthaltenen Metalle A, B und Cu im gewünschten stöchiometrischen Verhältnis und anschließendem Sintern unter Luft oder kontrollierter sauerstoffreicher Atmosphäre bzw. durch Oxidation von Gemischen oder Legierungen der enthaltenen Metalle, oder bei Anwendung von Dünnschichttechnik durch reaktives Aufdampfen oder Sputtern.

Das erhaltene supraleitende Material wird anschließend oder direkt im Rahmen der Präparation auf das ionenleitende Substrat aufgebracht.

Als ionenleitende Substrate eignen sich beispielsweise dotierte sauerstoffionenleitende Oxide wie $ZrO_2$, $ThO_2$, $CeO_2$ und/oder $Bi_2 O_3$, jeweils in der mit u.a. CaO oder $Y_2 O_3$ stabilisierten Form. Für den Fall, daß im Supraleiter der Formel (I) Sauerstoff teilweise durch Fluor ersetzt ist, kommen als Ionenleiter noch $CaF_2$, $LaF_3$, $BiF_3$ in Frage.

Dieser Einheit aus Ionenleiter und Supraleiter wird nun gemäß dem erfindungsgemäßen Verfahren auf der Seite des Ionenleiters ein chemisches Potential vorgegeben. Dazu eignet sich im Fall des Sauerstoffs als betrachteter elektronegativer Komponente eine konstante Restgasatmosphäre, die in weiten Druckbereichen variiert werden kann. Für den Fall, daß Sauerstoff die elektronegative Komponente im Ionengitter des Supraleiters darstellt, sind im Fall des $YBa_2 Cu_3 O_{7-\delta}$ Sauerstoffpartialdrücke um 1 bar vorteilhaft.

In besonders vorteilhafter Weise läßt sich das chemische Potential durch das Aufbringen von P im Gleichgewicht befindlichen festen Phasen mit N = P Komponenten auf das ionenleitende Substrat erzeugen, wobei eine der Komponenten der im ionenleitenden Substrat beweglichen Komponente entspricht. Wenn diese Komponente Sauerstoff ist. wie beispielsweise im Falle des Zirkondioxids, so läßt sich dieses chemische Potential durch das Gleichgewicht eines festen binären Oxids mit dem entsprechenden reinen Metall als zweiter Phase oder mit einem zweiten Oxid unterschiedlicher Wertigkeit erreichen. Entsprechendes gilt für Fluor als elektronegative Komponente. So eignen sich u.a. folgende zweiphasigen Systeme: Fe/FeO, Ni/NiO, Cu/$Cu_2$O, $Cu_2$O/CuO, Ca/$CaF_2$, Bi/$BiF_3$.

Auf diese meist plättchenförmige Anordnung aus ionenleitendem Substrat und darauf befindlichem Supraleiter bzw. aus dem oben angegebenen zweiphasigen System, ionenleitendem Substrat und darauf befindlichen Supraleiter werden nun beidseitig, d.h. sowohl auf der Seite des Substrats bzw. des zweiphasigen Systems als auch auf der Seite des Supraleiters, ein Kontakt aus einem Elektronenleiter angebracht. Dieser besteht üblicherweise aus Platin, Gold oder Silber. Als Kontaktmaterial für den zweiten Kontakt, der sich nicht am Supraleiter, sondern auf der Seite des konstanten chemischen Potentials der Komponente X befindet, lassen sich auch andere Oxide mit Perowskit-Struktur, wie z.B. $LaNiO_{3-\delta}$, verwenden.

Die nun an beide Kontakte anzulegende Spannung bewirkt in der beschriebenen Anordnung die Einstellung des Gehalts der elektronegativen Komponente im Ionengitter des Supraleiters und damit die Einstellung der Sprungtemperatur. Sie bemißt sich nach der Nernst'schen Gleichung. Danach ergibt sich die Spannung oder Elektromotorische Kraft (EMK)E, stromlos gemessen, nach

3

EP 0 313 964 B1

$$E = \frac{1}{nF} \left[ \mu_x \ (Supral.) - \mu_x \ (zweiter \ Kontakt) \right]$$

$$= E^0 + \frac{RT}{2nF} \ln P_{x_2} \ (Supral.)$$

Somit ist E eindeutig mit dem chemischen Potential $\mu_x$ bzw. dem Partialdruck

$$P_{x_2}$$

im Supraleiter verknüpft. n ist die Wertigkeit der im Ionenleiter beweglichen Ionen $X^{n^-}$. Damit ist auch der Gehalt an elektronegativer Komponente X im Supraleiter festgelegt.

Wird nun nach dem erfindungsgemäßen Verfahren, wird der Vorgang beispielsweise für X gleich Sauerstoff betrachtet, eine Spannung E' , die sich von der EMK unterscheidet, angelegt, dann fließt ein Sauerstoffionenstrom durch das $ZrO_2$. Ist E' größer als die EMK, werden Sauerstoffionen von der Bezugselektrode durch das $ZrO_2$ zum supraleitenden Material transportiert, wodurch der Sauerstoffgehalt erhöht wird. Umgekehrt wird der Sauerstoffgehalt im supraleitenden Material erniedrigt, wenn E' kleiner als die EMK gehalten wird. Durch die Veränderung des Sauerstoffgehalts ändert sich auch das chemische Potential $\mu(O_2)$ bzw. der Partialdruck $P(O_2)$. Generell wird die Spannung solange angelegt bis kein Stromfluß mehr stattfindet, und damit die neue EMK E der aufgezwungenen Spannung E' mit dem neuen Partialdruck $P(O_2)$ entspricht.

Mit dem erfindungsgemäßen Verfahren wird in überraschend einfacher Weise die Einstellung des Gehalts der elektronegativen Komponente im Ionengitter des Supraleiter mit Perowskit-Struktur und damit die Einstellung der Sprungtemperatur ermöglicht. Dieses Verfahren findet in einfacher und vor allem leicht reproduzierbarer Weise bei im Vergleich zum Stand der Technik tiefen Temperaturen, d.h. bereits bei Temperaturen unter 400°C statt. Unter besonderer Berücksichtigung des Ionenleiters und geeigneter Kontakte sind sogar noch tiefere Arbeitstemperaturen von z.B. 200°C zu bewerkstelligen. Ein weiterer Vorteil dieses Verfahrens besteht darin, daß damit die Regeneration von Supraleitern, deren Sprungtemperatur, der Sättigungsstromdichte mit und ohne Magnetfeld und der Anteile normalleitender Phasen durch Alterungsprozesse nicht mehr der Vorgabe entsprechen, ermöglicht wird. Generell gilt für das erfindungsgemäße Verfahren, daß sich bei den Supraleitern mit vom Perowskit abgeleiteter Struktur die Sprungtemperatur, der Sättigungsstromdichte mit und ohne Magnetfeld und der Anteile normalleitender Phasen in weiten Grenzen in dem für das Material charakteristischen Bereich einstellen und auch regenerieren läßt.

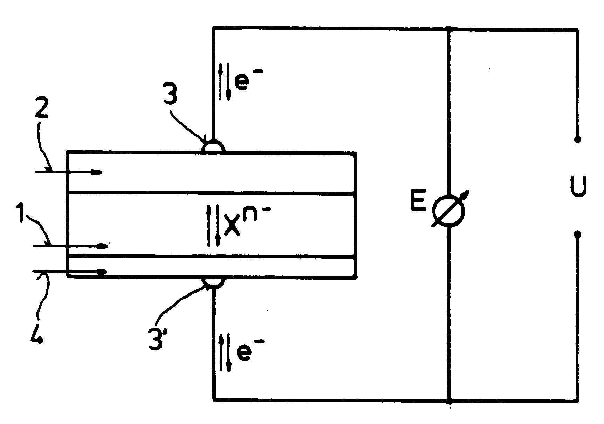

Zur beispielhaften Erläuterung des erfindungsgemäßen Verfahrens sei die Abbildung herangezogen. Sie zeigt ein ionenleitendes Substrat 1, beispielsweise ein mit $Y_2O_3$ dotiertes $ZrO_2$, auf dessen einer Seite der Supraleiter 2, beispielsweise der Formel $YBa_2Cu_3O_{7-\delta}$, und der elektronenleitende Kontakt 3 und auf dessen anderer Seite das das chemische Potential der elektronegativen Komponente bildende Gemisch 4, beispielsweise ein $Cu/Cu_2O$-Gemisch, sowie darauf wieder ein elektronenleitender Kontakt 3' aufgebracht ist. Durch Anlegen einer konstanten Spannung U an die Kontakte 3 und 3' mit der stromlos gemessenen EMK E wird durch den Transport der elektronegativen Komponente X der Gehalt dieser Komponente im Supraleiter 2 eingestellt.

**Patentansprüche**

1.  Verfahren zum Einstellen der Sprungtemperatur, der Sättigungsstromdichte mit und ohne Magnetfeld und der Anteile normalleitender Phasen bei keramischen Supraleitern mit vom Perowskit abgeleiteter Struktur durch Veränderung des Gehalts mindestens einer der elektronegativen Komponenten im Ionengitter des Supraleiters, dadurch gekennzeichnet, daß
    (1) auf einer Seite eines ionenleitenden Substrats, dessen bewegliche Ionensorte $X^{n^-}$ einer elektronegativen Komponente X des Supraleiters entspricht, ein Supraleiter mit vom Perowskit abgeleiteter Struktur aufgebracht und
    (2) auf der freien Seite des Supraleiters ein elektronenleitender Kontakt und ein zweiter elektronenleitender Kontakt an einer freien Seite des Ionenleiters angebracht wird, sowie

4

(3) dann am elektronenleitenden Kontakt auf der Seite des Ionenleiters das chemische Potential der elektronegativen Komponente X vorgegeben wird und

(4) schließlich durch ein bis zum Stromfluß Null dauerndes Anlegen einer konstanten Spannung der Gehalt der elektronegativen Komponente X im Ionengitter des Supraleiters eingestellt wird.

2. Verfahren zum Einstellen der Sprungtemperatur, der Sättigungsstromdichte mit und ohne Magnetfeld und der Anteile normalleitender Phasen bei keramischen Supraleitern mit vom Perowskit abgeleiteter Struktur durch Veränderung des Gehalts mindestens einer der elektronegativen Komponenten im Ionengitter des Supraleiters, dadurch gekennzeichnet, daß

(1) auf einer Seite eines ionenleitenden Substrats, dessen bewegliche Ionensorte $X^{n-}$ einer elektronegativen Komponente X des Supraleiters entspricht, ein Supraleiter mit vom Perowskit abgeleiteter Struktur aufgebracht und

(2) auf der freien Seite des Supraleiters ein elektronenleitender Kontakt und ein zweiter elektronenleitender Kontakt an einer freien Seite des Ionenleiters angebracht wird, sowie

(3) dann am elektronenleitenden Kontakt auf der Seite des Ionenleiters das chemische Potential der elektronegativen Komponente X vorgegeben wird und

(4) schließlich durch einen konstanten Stromfluß der Gehalt der elektronegativen Komponente X im Ionengitter des Supraleiters eingestellt wird.

3. Verfahren gemäß Anspruch 1 oder 2, dadurch gekennzeichnet, daß das chemische Potential der elektronegativen Komponente X durch eine konstante Restgasatmosphäre mit der elektronegativen Komponente X als Bestandteil erzeugt wird.

4. Verfahren gemäß Anspruch 1 oder 2, dadurch gekennzeichnet, daß das chemische Potential der elektronegativen Komponente X durch ein Gemisch aus P Phasen mit N gleich P Komponenten, von denen eine die elektronegative Komponente X ist, erzeugt wird.

**Claims**

1. A method for adjusting the transition temperature, the saturation current density with and without a magnetic field and the proportions of normally conducting phases in ceramic superconductors having a structure derived from perovskite, by changing the content of one or more of the electronegative components in the ion lattice of the superconductor, wherein

(1) a superconductor having a structure derived from perovskite is applied to one side of an ion-conducting substrate whose mobile ion type $X^{n-}$ corresponds to an electronegative component X of the superconductor and

(2) an electron-conducting contact is mounted on the free side of the superconductor and a second electron-conducting contact is mounted on a free side of the ion conductor, and

(3) the chemical potential of the electronegative component X is then preset at the electron-conducting contact on the ion conductor side and

(4) finally the content of the electronegative component X in the ion lattice of the superconductor is adjusted by applying a constant voltage until the current flow reaches zero.

2. A method for adjusting the transition temperature, the saturation current density with and without a magnetic field and the proportions of normally conducting phases in ceramic superconductors having a structure derived from perovskite, by changing the content of one or more of the electronegative components in the ion lattice of the superconductor, wherein

(1) a superconductor having a structure derived from perovskite is applied to one side of an ion-conducting substrate whose mobile ion type $X^{n-}$ corresponds to an electronegative component X of the superconductor and

(2) an electron-conducting contact is mounted on the free side of the superconductor and a second electron-conducting contact is mounted on a free side of the ion conductor, and

(3) the chemical potential of the electronegative component X is then preset at the electron-conducting contact on the ion conductor side and

(4) finally, the content of the electronegative component X in the ion lattice of the superconductor is adjusted by means of a constant current flow.

3. A method as claimed in claim 1 or 2, wherein the chemical potential of the electronegative component X is obtained by means of a constant residual gas atmosphere having the electronegative component X as a constituent.

4. A method as claimed in claim 1 or 2, wherein the chemical potential of the electronegative component X is obtained by means of a mixture of P phases with $N = P$ components, one of which is the electronegative component X.

**Revendications**

1. Procédé pour régler la température critique, la densité du courant de saturation, avec et sans champ magnétique et la proportion des phases à conductivité normale de supraconducteurs céramiques, avec une structure dérivée de la Perovskite, par modification de la teneur en au moins l'un des composants électronégatifs dans le réseau ionique du supraconducteur, caractérisé en ce que

(1) un supraconducteur dont la structure est dérivée de la Perovskite est appliqué sur une face d'un substrat conducteur d'ions, dont la sorte d'ions mobiles $X^{n-}$ correspond à un composant électronégatif X du supraconducteur,

(2) un premier contact conducteur d'électrons est appliqué sur la face libre du supraconducteur et un deuxième contact conducteur d'électrons est appliqué sur une face libre du conducteur d'ions, et

(3) le potentiel chimique du composant électronégatif X est ensuite prédéterminé sur le contact conducteur d'électrons, sur la face du conducteur d'ions et

(4) enfin, la teneur du composant électronégatif X dans le réseau d'ions du supraconducteur est réglée au moyen d'une tension constante appliquée durablement jusqu'à l'atteinte d'un flux de courant nul.

2. Procédé pour régler la température critique, la densité du courant de saturation, avec et sans champ magnétique et la proportion des phases à conductivité normale de supraconducteurs céramiques, avec une structure dérivée de la Perovskite, par modification de la teneur en au moins l'un des composants électronégatifs dans le réseau ionique du supraconducteur, caractérisé en ce que

(1) un supraconducteur dont la structure est dérivée de la Perovskite est appliqué sur une face d'un substrat conducteur d'ions, dont la sorte d'ions mobiles $X^{n-}$ correspond à un composant électronégatif X du supraconducteur,

(2) un premier contact conducteur d'électrons est appliqué sur la face libre du supraconducteur et un deuxième contact conducteur d'électrons est appliqué sur une face libre du conducteur d'ions, et

(3) le potentiel chimique du composant électronégatif X est ensuite prédéterminé sur le contact conducteur d'électrons, sur la face du conducteur d'ions et

(4) enfin, la teneur du composant électronégatif X dans le réseau ionique du supraconducteur est réglée au moyen d'un flux de courant constant.

3. Procédé selon la revendication 1 ou 2, caractérisé en ce que le potentiel chimique du composant électronégatif X est produit au moyen d'une atmosphère de gaz résiduel constante ayant le composant électronégatif X à titre de composant.

4. Procédé selon la revendication 1 ou 2, caractérisé en ce que le potentiel chimique du composant électronégatif X est produit au moyen d'un mélange de P phases à N égal P composants, dont l'un est le composant électronégatif X.